# EUROPEAN PATENT APPLICATION

(11) **EP 4 818 733 A1**
(43) Date of publication of application: **07.10.2026**
(21) Application number: 25168553.3
(22) Date of filing: 04.04.2025
(51) Int. Cl.: G01R 33/48, G01R 33/561

(54) **METHOD FOR OPERATING A MAGNETIC RESONANCE DEVICE, MAGNETIC RESONANCE DEVICE, COMPUTER PROGRAM AND STORAGE MEDIUM**

(71) Applicant: Siemens Healthineers AG, 91301 Forchheim (DE)
(72) Inventor: Buonincontri, Guido, 50059 Vinci (IT); Nittka, Mathias, 91083 Baiersdorf (DE)
(74) Representative: Siemens Healthineers Patent Attorneys

(57) **Abstract**

Computer-implemented method for operating a magnetic resonance device (1) for acquiring spatially resolved magnetic resonance data (7),
- wherein a segmented turbo spin echo sequence (12), that comprises multiple subsequences (13-16), is used to acquire the magnetic resonance data (7),
- wherein each one of the subsequences (13-16) acquires data for a different segment (34, 35) of a sampled k-space (33),
- wherein each subsequence (13-16) comprises multiple pulse trains (17-20), each pulse train (17-20) comprising an excitation pulse (21) preceding multiple refocusing pulses (22, 23), and
- wherein the multiple pulse trains (17-20) of the respective subsequence (13-16) use mutually different excitation pulses (21) to acquire data for different spectral bins (24-27) and/or different spatial slices of the magnetic resonance data (7),
- wherein a repetition time (28-30), that is defined for the respective subsequence (13-16) as the time between the first excitation pulse (21) within that subsequence (13-16) and the first excitation pulse (21) of the subsequence (13-16) that precedes the respective subsequence (13-16) in the segmented turbo spin echo sequence (12), is different for at least two of the subsequences (13-16).

## Description

The invention concerns a computer-implemented method for operating a magnetic resonance device for acquiring spatially resolved magnetic resonance data, wherein a segmented turbo spin echo sequence, that comprises multiple subsequences, is used to acquire the magnetic resonance data, wherein each one of the subsequences acquires data for a different segment of a sampled k-space, wherein each subsequence comprises multiple pulse trains, each pulse train comprising an excitation pulse preceding multiple refocusing pulses, and wherein the multiple pulse trains of the respective subsequence use mutually different excitation pulses to acquire data for different spectral bins and/or different spatial slices of the magnetic resonance data. Additionally, the invention concerns a magnetic resonance device, a computer program and an electronically readable storage medium.

When exciting a previously excited slice or volume in magnetic resonance imaging, spins that are still excited from a previous excitation pulse are typically considered to be without transverse coherence and their contribution to the received signals can be neglected, due to dedicated spoiling pulses and/or gradients and/or due to various off-resonance RF-pulses and gradients that are used for different purposes in the sequence anyway, e.g. as excitation pulses in a different pulse train then the one used to excite the respective spin. Therefore, it is not necessary to wait until the longitudinal magnetization reaches a steady-state, before another pulse train that excites the same slice or spectral bin can be started. The spoiled transversal magnetization will however not contribute to the signal acquired with the new pulse train. Therefore, shorter repetition times between excitations of the same spectral bin and/or slice can noticeably decrease the image contrast in a magnetic resonance image that is reconstructed from the magnetic resonance data.

In a turbo spin echo sequence, a pulse train with a single excitation pulse is followed by multiple refocusing pulses, wherein a spin echo signal is generated and acquired for each one of the refocusing pulses. When applying a magnetic gradient field to the sampled volume between the refocusing pulses, the phase encoding of the sample, e.g., or for the tissue of a patient, is changed between the echoes. Therefore, different spin echoes acquired in the same pulse train correspond to different k-space positions. Therefore, the acquisition of all desired k-space points can be sped up compared to a simple spin echo sequence that would use only a single refocusing pulse after each excitation pulse, without shortening the repetition time between excitation pulses.

Turbos spin echo sequences, that are also called also called fast spin echo sequences, are well known in the prior art and shall therefore not be discussed in further detail. Since the echo intensity for later refocusing pulses and therefore the image quality can suffer, when pulse sequences use a large number of refocusing pulses, a segmented turbo spin echo sequence, that is also called multi-shot sequence, is typically used, in which several separate pulse trains comprising a respective excitation pulse and multiple refocusing pulses are used to sample a respective segment of the k-space.

When metal is present in the field of view of a magnetic resonance tomography, it induces spatial variations in the magnetic field, resulting in image distortions and signal loss. To address this issue, techniques like View Angle Tilting (VAT), Slice-Encoding for Metal Artifact Correction (SEMAC), or 3D Multi-Spectral Imaging (MSI) are used. These methods typically introduce additional encoding for off-resonance to resolve different degrees of image distortions, as will be explained below for an example of the MSI-technique.

In general, distortions in magnetic resonance imaging in the vicinity of metal, e.g. of implants, can be reduced, when a slice selection is avoided and the full volume is imaged, e.g., by a 3D fast spin echo technique. The bandwidth of selective refocusing pulses in such techniques is, however, typically limited to a few kHz. Even at a relatively low field strength of 1.5 T, the presence of metal implants can lead to a frequency offset in the surrounding tissue of 10 kHz or more, therefore leading to regions that will not show any response signal when exciting close to the normal Larmor frequency of tissue. This issue can be avoided by acquiring images at multiple center frequencies of the excitation and refocusing pulses and then using either a maximum intensity projection or a sum of squares in the image domain. Such an imaging approach is, e.g., discussed in detail in K. M. Koch et al., A Multispectral Three-Dimensional Acquisition Technique for Imaging Near Metal Implants, Magnetic Resonance in Medicine 61:381-390 (2009).

Despite being effective in reducing the artifacts generated by metal, such techniques have the drawback of requiring multiple acquisitions to encode for the resonance frequency, hence increasing the acquisition time significantly. While it is, in principle, possible, to at least partially compensate for the additional required acquisitions by speeding up the individual acquisitions, e.g., by using a lower resolution to sample the k-space and/or by reducing the repetition Time (TR), which corresponds to the amount of time between successive pulse sequences applied for a given spectral bin to an excited region, e.g., the same slice or to the whole volume in sequences that use a non-selective excitation, such approaches can lead to a strong loss in image quality, in particular with respect to contrast and/or resolution.

The invention is and therefore based on the problem of reducing the amount of time required for an acquisition of a magnetic resonance tomography, while keeping the image quality high, in particular when metal is present in the field of view and/or when using a multi shot technique.

The problem is solved by the initially discussed computer-implemented method for operating a magnetic resonance device wherein a repetition time, that is defined for the respective subsequence as the time between the first excitation pulse within that subsequence and the first excitation pulse of the subsequence that precedes the respective subsequence in the segmented turbo spin echo sequence, is different for at least two of the subsequences.

As discussed below, the use of different repetition times for different ones of the subsequences leads to an improved image quality, in particular to a higher image contrast, when speeding up the acquisition by lowering repetition times compared to a flat decrease of all repetition times to the same value.

When a segmented turbo spin echo sequence is used to acquire data for multiple spectral bins and/or slices, excitations for different spectral bins and/or slices are advantageously interleaved. Therefore, various other spectral bins and/or slices are excited, before the same spectral bin and/or slice is excited again. The repetition time for the individual spectral bin and/or slice is therefore typically maximized, when the spectral bins and/or the slices are excited in the same order in each one of the subsequences.

The following explanation will therefore focus on an exemplary embodiment, in which the excitation pulse of the first pulse train of each one of the subsequences will always excite the same spectral bin and/or slice and therefore corresponds to the repetition in time for that spectral bin and/or a slice in a non-interleaved sequence. For simplicity's sake it will also be assumed for now, that the timing of the pulse trains within the different subsequences is the same and that the spectral bins and/or slices excited in the further pulse trains following the respective first pulse train of the respective subsequence also have the same repetition time.

In segmented turbo spin echo sequences, the repetition time is typically chosen to be quite a bit longer than a minimum repetition in time that would result, when the next subsequence would be started at once, after all of the magnetic resonance data for the previous subsequence is acquired. It would therefore, in principle, be possible, to speed up the acquisition quite a bit by using a lower repetition time for all subsequences. This would, however, typically lead to a strongly lowered contrast and, therefore, strongly affect the interpretability of a reconstructed image.

It was, however, found, that different regions of the k-space have a different relevance for the image contrast. The repetition time can, therefore, typically be lowered quite a bit for many of the segments of the sampled k-space and, therefore, for many of the subsequences, without noticeably worsening the image contrast, as long as a sufficiently high repetition time is used before each subsequence that samples those regions of the k-space that have a strong influence in the image contrast.

As discussed in more detail below, typically the center of the k-space should be sampled using relatively long repetition times, while the outer area of the k-space can be sampled with shorter repetition times. It should be noted, that this approach can lead to a slight loss of high-frequency information and therefore a slight blurring of the reconstructed image. When images using this approach are compared to images based on image acquisitions that reach the same amount of speedup by lowering all repetition times to the same value, the use of different repetition times and the resulting improved contrast was however found to strongly improve the image interpretability, which is, e.g., highly relevant for diagnostic tasks.

In particular, the different pule trains can also use mutually different refocusing pulses, that can, e.g., be bandlimited to only refocus spins with a Lamor frequency within the respective spectral bin and/or selected slice. Since each pulse train comprises an excitation pulse, the first pulse train of the respective subsequence corresponds to the excitation pulse of the first pulse train of that respective subsequence.

The respective repetition time for the respective subsequence can depend on a distance of the respective segment of the k-space, for which data is acquired by the respective subsequence, from the center of the k-space. It was found, that regions of the k-space closer to the center of the k-space, and therefore concerning lower image frequencies, are central for achieving a large image contrast in a reconstructed magnetic resonance image. It is therefore advantageous, to take the distance between the respective sampled segment of the k-space and the k-space center into account, when choosing repetition times.

It should be noted, that each pulse train in the respective subsequence typically samples the k-space along the same trajectory. Typical sequences will only acquire a rather small segment of the overall k-space in each subsequence, e.g., only 4 to 64 echoes, in particular 32 to 54 echoes, e.g., 40 or 48 echoes. The sequence can, therefore, easily be designed in such a way, that all points of the trajectory sampled during the respective subsequence have approximately the same distance to the center of the k-space. The distance can then, e.g., be chosen to be the distance of the center of the sampled trajectory or the median or average distance of the trajectory to the k-space center. The distance can be determined based on all coordinates of the k-space, e.g. as an Euclidean distance, or only one or two coordinates can be considered when calculating the distance.

It should be noted, that the first subsequence can be assumed to have an infinite or at least very long repetition time, since the segmented turbo spin echo sequence will typically not comprise any or any relevant excitation pulses prior to the first subsequence. Therefore, the first subsequence can, e.g., be used to sample the center of the k-space and/or the immediate area surrounding this center.

The respective repetition time for the respective subsequence can be a monotonically decaying function and/or a polynomial or exponential function of the distance of the respective segment of the k-space, for which data is acquired by the respective subsequence, from the center of the k-space. As discussed above, it is typically advantageous, to use lower repetition times for subsequences that acquire data for k-space segments that are further removed from the k-space center. A smooth, in particular, polynomial or exponential, decay of the repetition time with the distance was found to provide good results.

The segmented turbo spin echo sequence can sample a given set of k-space points, wherein the k-space points are grouped into the segments of the sampled k-space, that are sampled by a respective one of the subsequences, according to their distance from the center of the k-space. Such a grouping of the sampled k-space points can minimize the difference between the actual distance of a sampled k-space point from the center and the distance used to determine the repetition time for the subsequence used to sample this point, therefore maximizing the advantage of choosing the repetition time based on the distance of the respective segment from the k-space center.

Due to the technical functionality of turbo spin echo sequence, the k-space points sampled by a respective pulse train and therefore, in particular, by a respective subsequence, lie on a continuous trajectory. The segments can, e.g., be chosen in such a way, that this trajectory lies in a distance window with a given size. Therefore, a sampling scheme can be created, wherein each pulse train is confined to encoding a k-space region within a certain distance window from k-space center. An index reordering can then be used to populate the k-space based on the received echoes.

The segmented turbo spin echo sequence can acquire magnetic resonance data for multiple different spectral bins, wherein a spatially non-selective excitation of the field of view is used. In particular, no slice selection gradients are used during the excitation pulses. A spatially non-selective excitation avoids distortions that can be caused by metal implants or other magnetic objects in the field of view. The use of multi-spectral imaging can avoid signal loss in this case, as already discussed above.

That magnetic resonance data can, in particular, be acquired for at least 5 or at least 10 spectral bins. Additionally or alternatively, the spectral bins can be spaced apart by between 500 Hz and 2 kHz and/or have a bandwidth between 1.5 kHz and 2.5 kHz.

The suggested ranges are based on several observations: It was found, that the spectral bins should cover an overall bandwidth of at least 10 kHz, to allow for an imaging of all tissue, when a main magnet at 1.5 T is used. The required bandwidth scales approximately linearly with the field strength of the main magnet. Common design approaches to bandlimited refocusing pulses can limit the available bandwidth to a few kHz, leading to the suggested bandwidth limits. Typically, a sizeable overlap between spectrally adjacent spectral bins should be used, to provide a stable signal intensity across the full bandwidth after combining the spectral bins.

Typically, it is advantageous, to avoid a consecutive sampling of overlapping spectral bins. The ordering of the pulse trains and therefore of the sampling of the spectral bins can in the respective subsequence can therefore, e.g., be chosen in such a way, that at first only the odd and then only the even spectral bins are sampled.

The number of refocusing pulses in each pulse train of a respective subsequence can be different for at least two of the subsequences. In particular the number of the used refocusing pulses can increase monotonically with an increase of the distance of the segment of the k-space sampled by the respective subsequence from the center of the k-space. The use of shorter echo trains close to the k-space center can further improve the image contrast, while using longer echo trains in the outer area of the k-space can be used to speed up the acquisition.

For at least two of the subsequences at least two of the pulse trains that are used to sample the same spectral bin and/or slice in these subsequences can use excitation pulses with mutually different pulse shapes and/or can use refocusing pulses in the same position of the respective pulse train having mutually different pulse shapes. The pulse shape of the used excitation and/or refocusing pulses can, in particular, depend on a distance of the respective segment of the k-space, for which data is acquired by the respective subsequence, from the center of the k-space.

In this context, the spectral bin and/or slice sampled by the respective pulse train is, in particular, defined by the spectral center of the excitation pulse and/or their refocusing pulses. In the simplest case, the mutually different pulse shapes only vary due to a change in amplitude. It is, in particular, possible, to modify the amplitude of for the refocusing pulses and therefore of the resulting flip angle, in particular to adjust the amount of energy deposited into a patient, e.g., when a different number of refocusing pulses is used in the pulse trains of the different subsequences, as discussed above.

Additionally or alternatively, in the spectral composition, in particular the bandwidth of the respective excitation and/or refocusing pulse can be different due to the different pulse shape, e.g., when using mutually different envelope shapes. Typically, a certain amount of overlap is desired for the excitation pulses and/or refocusing pulses when acquiring data for different spectral bins and/or slices, to ensure, that the spectral range and/or of the acquired volume is completely and evenly covered. By adjusting the pulse shape to reduce the spectral overlap, the temporal distance between pulse trains acquiring data for adjacent spectral bins and/or slices can be reduced. This can be advantageous for subsequences using a relatively short repetition time, e.g. in an outer area of the k-space, and/or to allow for a shortening of the time between multiple pulse trains within the same sequence.

In particular, the number of pulse trains in the respective subsequence can be different for at least two of the subsequences. Lowering the number of pulse trains and therefore, e.g., the number of spectral bins, for which data is acquired, for at least one of the subsequences, can further reduce the required acquisition time.

It is, in particular possible, to sample a smaller number of spectral bins with an increasing distance of the segment of the k-space sampled by the respective subsequence from the center of the k-space. In particular, the number of used pulse trains can be smaller for an outer area of the k-space compared to an inner area of the k-space. It is, e.g., possible, to not acquire data for the spectral bins comprising the highest and/or lowest frequencies in an outer area of the k-space, since these spectral bins typically only affect imaging very close to metal artifacts and an increased smearing of the image close to metal artifacts is typically acceptable.

The invention also concerns a magnetic resonance device, comprising a main magnet for generating a main magnetic field, acquisition equipment comprising a gradient coil assembly and a radio frequency coil assembly, and a control device, wherein the control device is designed to control the acquisition equipment, to acquire magnetic resonance data according to the method of one of the preceding claims.

All features and remarks regarding the method according to the invention may also be applied to the magnetic resonance device according to the invention and vice versa. Hence, the same advantages can be achieved.

The control device can comprise at least one processor and at least one storage means. Functional units may be implemented using hardware and/or software.

The invention also concerns a computer program comprising instructions that, when executed on a control device of a magnetic resonance device cause the control device to perform the inventive method.

A computer program according to the invention may be directly loaded into a storage means of a control device of a magnetic resonance device and comprises program means, such that, when the computer program is executed on the control device, the control device is caused to perform the steps of a method according to the invention. The computer program may be stored on an electronically readable storage medium according to the invention, which hence comprises control information stored thereon, which comprises at least a computer program according to the invention, such that, when the electronically readable storage medium is used in a control device of a magnetic resonance device, the control device is configured to perform a method according to the invention.

Therefore, the invention also concerns an electronically readable storage medium, on which a computer program according to the present invention is stored. The electronically readable storage medium may be a non-transient medium, for example a CD-ROM, or a transient medium, e.g. a random-access memory (RAM).

*Independent of the grammatical term usage, individuals with male, female or other gender identities are included within the term.*

Other objects and features of the present invention will become apparent from the following detailed description considered in conjunction with the accompanying drawings. The drawings, however, are only principle sketches designed solely for the purpose of illustration and do not limit the invention. The drawings show:
- Fig. 1: an exemplary embodiment of a magnetic resonance device according to the invention,
- Fig. 2: a segmented turbo spin echo sequence used in an exemplary embodiment of the computer-implemented method for operating a magnetic resonance device according to the invention,
- Fig.3: an exemplary pulse train used in the segmented turbo spin echo sequence shown in fig. 2,
- Fig. 4: an exemplary dependence of the repetition time on the distance of a k-space segment for which data is acquired from the center of the k-space, and
- Fig. 5: an exemplary segmentation of the k-space.

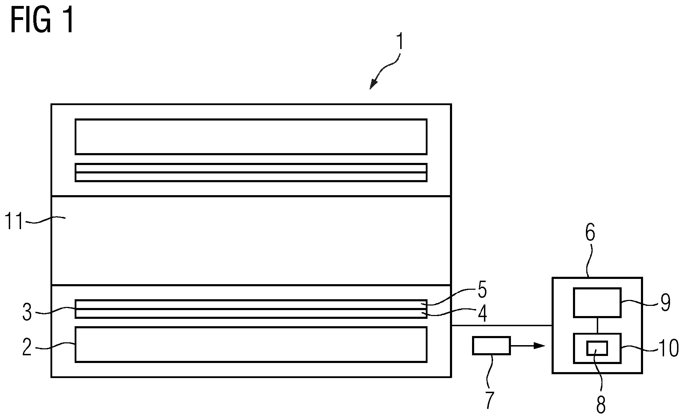

Fig. 1 shows a magnetic resonance device1, comprising a main magnet 2 for generating a main magnetic field, acquisition equipment 3 comprising a gradient coil assembly 4 and a radio frequency coil assembly 5, and a control device 6. The patient (not shown) is placed within the field of view 11 of the magnetic resonance device, that corresponds to the bore of the main magnet 2 in the example. The control device 6 is designed to acquiring spatially resolved magnetic resonance data 7, using a segmented turbo spin echo sequence 12, as discussed in detail below.

In the example, the control device 6 is implemented by a programmable processor 9, e.g. a CPU, a GPU and/or a FPGA, and a computer program that is stored in an electronically readable storage medium 10, e.g., in a memory chip. When the instructions of the computer program 8 are executed by the processor 6, the control device controls the acquisition equipment 3 to acquire magnetic resonance data 7 using a segmented turbo spin echo sequence 12.

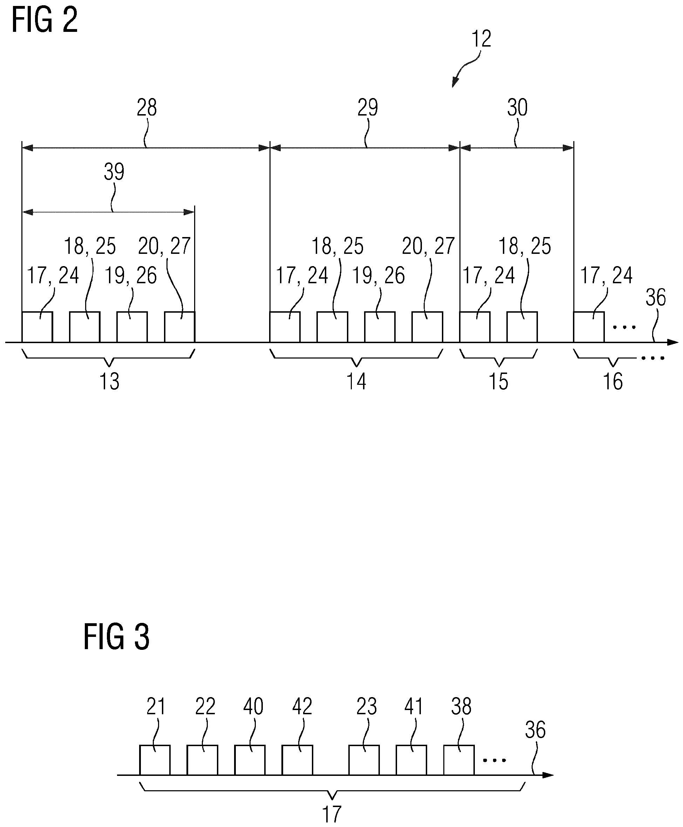

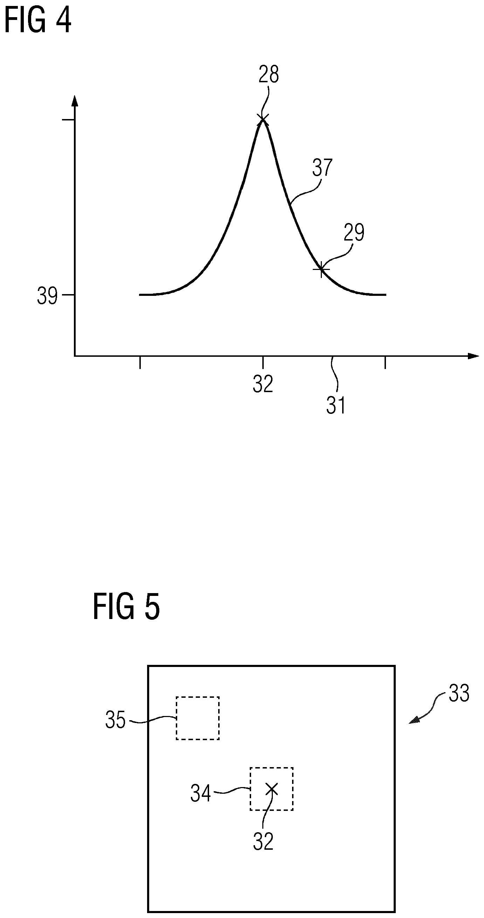

The segmented turbo spin echo sequence 12 comprises multiple subsequences 13-16, as shown in fig. 2, that each are designed to acquire magnetic resonance data 7, for a respective segment 34, 35 of the k-space 33. Exemplary segments of the k-space are schematically shown in fig. 5. It should be noted, that in many cases a three-dimensional k-space is used and the two-dimensional representation in fig. 5 is used only for reasons of simplicity and clarity. Additionally, it should be noted, that, in real live applications, the k-space segments 34, 35 are chosen to be quite small and, e.g., comprise only 30-60 k-space points.

In the example, the presence of metal, e.g. a metal implant, it is expected within the field of view 11. To avoid or at least minimize an image distortion due to a magnetic field inhomogeneity caused by the metal, a spatially non-selective excitation of the field of view 11 is used. As already discussed in the general part of the description, such a field inhomogeneity will also cause shifts in the Lamour-frequency of spins of the tissue close to the metal, that can exceed the bandwidth of common excitation and/or refocusing pulses. To ensure, that even tissue close to the metal is depicted correctly, a multispectral imaging technique is used, in which magnetic resonance data 7 is acquired for multiple spectral bins 24-27.

For this purpose, each of the subsequences 13-16 comprises multiple pulse trains 17-20 that are output via the radio frequency coil assembly 5 at different times 36, wherein each of the pulse trains 17-20 acquire data for different spectral bin 24-27. While only 4 spectral bins 24-27 are used for illustrative purposes, advantageous embodiments will acquire magnetic resonance data for at least 5 or at least 10 spectral bins 24-27. The spectral bins 24-27 can, e.g., be spaced apart by approximately 1 kHz to 2 kHz and have a bandwidth of, e.g., approximately 2 kHz.

Since it can be assumed, that the image acquisitions for different spectral bins 24-27 hardly interact, an interleaved acquisition is used, wherein each subsequence comprises multiple pulse trains that acquire different spectral components 24-27 of the magnetic resonance data 7 for the same k-space segment 34, 35.

As shown in fig. 3 for the pulse train 17, each one of these pulse trains 17-20 comprises an excitation pulse 21 followed by multiple refocusing pulses 22, 23. To achieve the spectral selectivity, mutually different excitation pulses 21 and, in particular, mutually different refocusing pulses 22, 23 are used for the different pulse trains 17-20 of the respective subsequence. It should be noted, that the discussed approach for selecting different spectral bins 24-27 could additionally or alternatively be used in conjunction with a slice selection gradient, to achieve a spatial selectivity.

After each one of the refocusing pulses 22, 23, a phase encoding step 40, 41 is performed by driving the gradient coil assembly 4 to select the k-space position, for which an echo signal 38, 42 is acquired.

Since there is a typically only a relatively small spectral overlap of the different spectral bins 24 to 27 caused by the spectral width of excitation and refocusing pulses 21-23, the image contrast of the acquisition mainly depends on the repetition time between a repeat excitation of the same spectral bin 17-20. Therefore, the repetition time 28-30 is defined for the respective subsequence 13-16 as the time between the first excitation pulse 21 within that subsequence 13-16 and the first excitation pulse 21 of the subsequence 13-16 that precedes the respective subsequence 13-16 in the segmented turbo spin echo sequence 12, as shown in fig. 2. As already discussed in the general part of the description, a shortening of the acquisition time without an undue loss in contrast can be achieved, when this repetition time 28-30 is different for different subsequences. In general, the repetition time can be decreased monotonically with an increasing distance of the segment 34, 35 of the k-space, for which data is acquired by the respective subsequence 13 to 16, from the center 32 of the k-space 33.

An example for the determination of the repetition time 28-30 will now be given with additional reference to figures 4 and 5 for a case, that is slightly simplified in comparison to the segmented turbo spin echo sequence 12 shown in fig. 2, in that all of the subsequences 13-16 are assumed to comprise the same number of pulse trains 17-20. In this case the length 39 of the pulse train provides a lower limit to the possible repetition times 28-30. As shown for an exemplary function 37 for determining the respective repetition time 28-30 from the distance 31 in fig. 4, this minimum can be reached, when the distance reaches its maximum and therefore at the outer edges or corners of the k-space. At the center of the k-space, the repetition time should reach its maximum. In the example, the function 37 is a monotonically decaying third-order polynomial function 37 of the distance 31. This the distance is plotted for a single k-space coordinate in the example, it increases in both directions from the center 32 of the k-space 33.

The segment 34 one of the k-space 33, comprising the center 32 of the k-space 33, is acquired by the subsequence 14, having the largest repetition time 28. Since the subsequence 15 samples a segment 35 of the to the k-space 33, that has a quite large distance from the center 32 of the k-space 33, the function 37 provides a lower repetition time 29.

In the example shown in Fig. 2, the subsequence 15 uses a lower number of pulse trains 17-20 then the subsequences 13, 14. This can be advantageous to further lower the time required for the acquisition of the magnetic resonance data. As already discussed previously, the segment 35 of the k-space 33, for which data is acquired by the subsequence 15, is spaced rather far away from the center 32 of the k-space 33 and therefore has little consequence for the image contrast. It can therefore be sufficient, to sample a lower number of spectral bins 17, 18 for this segment 35, therefore allowing the repetition time 30 for the following subsequence 16 to drop below the previously discussed minimum.

It would also be possible, to adjust the number of refocusing pulses 22, 23 in each pulse train 17-20 of a respective subsequence 13-16 and/or the shape of the excitation and/or refocusing pulses 21-23 in the respective subsequence 13-16, based on the distance of the segment 34, 35, which is sampled by the respective subsequence 13-16, from the center 32 of the k-space 33. The advantages and effects of such a modification where already discussed in detail in the general part of the description.

## Claims

1. Computer-implemented method for operating a magnetic resonance device (1) for acquiring spatially resolved magnetic resonance data (7),
- wherein a segmented turbo spin echo sequence (12), that comprises multiple subsequences (13-16), is used to acquire the magnetic resonance data (7),
- wherein each one of the subsequences (13-16) acquires data for a different segment (34, 35) of a sampled k-space (33),
- wherein each subsequence (13-16) comprises multiple pulse trains (17-20), each pulse train (17-20) comprising an excitation pulse (21) preceding multiple refocusing pulses (22, 23), and
- wherein the multiple pulse trains (17-20) of the respective subsequence (13-16) use mutually different excitation pulses (21) to acquire data for different spectral bins (24-27) and/or different spatial slices of the magnetic resonance data (7),
**characterized in that** a repetition time (28-30), that is defined for the respective subsequence (13-16) as the time between the first excitation pulse (21) within that subsequence (13-16) and the first excitation pulse (21) of the subsequence (13-16) that precedes the respective subsequence (13-16) in the segmented turbo spin echo sequence (12), is different for at least two of the subsequences (13-16).

2. Computer-implemented method according to claim 1, **characterized in that** the respective repetition time (28-30) for the respective subsequence (13-16) depends on a distance (31) of the respective segment (34, 35) of the k-space (33), for which data is acquired by the respective subsequence (13-16), from the center (32) of the k-space (33).

3. Computer-implemented method according to one of the preceding claims, characterized that the respective repetition time (28-30) for the respective subsequence (13-16) is a monotonically decaying function (37) and/or a polynomial or exponential function (37) of the distance (31) of the respective segment (34, 35) of the k-space (33), for which data is acquired by the respective subsequence, from the center (32) of the k-space (33).

4. Computer-implemented method according to one of the preceding claims, **characterized in that** the segmented turbo spin echo sequence (12) samples a given set of k-space points, wherein the k-space points are grouped into the segments (34, 35) of the sampled k-space (33), that are sampled by a respective one of the subsequences (13-16), according to their distance (31) from the center (32) of the k-space (33).

5. Computer-implemented method according to one of the preceding claims, **characterized in that** the segmented turbo spin echo sequence acquires magnetic resonance data (7) for multiple different spectral bins (24-27), wherein a spatially non-selective excitation of the field of view (11) is used.

6. Computer-implemented method according to one of the preceding claims, **characterized in that** magnetic resonance data (7) is acquired for at least 5 or at least 10 spectral bins (24-27) and/or **in that** the spectral bins (24-27) are spaced apart by between 500 Hz and 2 kHz and/or have a bandwidth between 1.5 kHz and 2.5 kHz.

7. Computer-implemented method according to one of the preceding claims, **characterized in that** the number of refocusing pulses (22, 23) in each pulse train (17-20) of a respective subsequence (13-16) is different for at least two of the subsequences (13-16).

8. Computer-implemented method according to one of the preceding claims, **characterized in that** for at least two of the subsequences (13-16) at least two of the pulse trains (17-20) that are used to sample the same spectral bin (24-27) and/or slice in these subsequences (13-16) use excitation pulses (17) with mutually different pulse shapes and/or use refocusing pulses (22, 23) in the same position of the respective pulse train (17-20) having mutually different pulse shapes.

9. Computer-implemented method according to one of the preceding claims, **characterized in that** the number of pulse trains (17-20) in the respective subsequence (13-16) is different for at least two of the subsequences (13-16).

10. Magnetic resonance device, comprising a main magnet (2) for generating a main magnetic field, acquisition equipment (3) comprising a gradient coil assembly (4) and a radio frequency coil assembly (5), and a control device (6), wherein the control device is designed to control the acquisition equipment (3), to acquire magnetic resonance data (7) according to the method of one of the preceding claims.

11. Computer program comprising instructions that, when executed on a control device (6) of a magnetic resonance device (1) cause the control device (6) to perform a method according to any of the claims 1 to 9.

12. Electronically readable storage medium, on which a computer program (8) according to claim 11 is stored.
